# EUROPEAN PATENT APPLICATION

(11) **EP 4 383 508 A1**
(43) Date of publication of application: **12.06.2024**
(21) Application number: 22867558.3
(22) Date of filing: 27.07.2022
(51) Int. Cl.: H02J 7/00, G01R 19/165, H02M 3/158

(54) **BATTERY MANAGEMENT DEVICE AND METHOD FOR OPERATING SAME**

(30) Priority: 08.09.2021 KR 20210120043
(71) Applicant: LG Energy Solution, Ltd., Seoul 07335 (KR)
(72) Inventor: JO, Lyang Wook, Daejeon 34122 (KR)
(74) Representative: Plasseraud IP
(86) International application number: PCT/KR2022/011066
(87) International publication number: WO 2023/038289

(57) **Abstract**

A battery management apparatus according to an embodiment disclosed herein includes a buck converter configured to generate a driving voltage based on a voltage of a battery pack, a comparator configured to compare a divided voltage generated based on the voltage of the battery pack with a reference voltage and control an operation of the buck converter based on a result of the comparison, and a detector configured to detect whether the battery pack and a target device are connected and control an operation of the comparator based on a result of the detection.

## Description

### [TECHNICAL FIELD]

### CROSS-REFERENCE TO RELATED APPLICATION

This application claims priority to and the benefit of Korean Patent Application No. 10-2021-0120043 filed in the Korean Intellectual Property Office on September 8, 2021, the entire contents of which are incorporated herein by reference.

### TECHNICAL FIELD

Embodiments disclosed herein relate to a battery management apparatus and an operating method thereof.

### [BACKGROUND ART]

An electric vehicle is supplied with electricity from outside to charge a battery cell, and then a motor is driven by a voltage charged in the battery cell to obtain power. The battery cell of the electric vehicle may have heat generated therein by chemical reaction occurring in a process of charging and discharging electricity, and the heat may impair performance and lifetime of the battery cell. Thus, a battery management apparatus (or a battery management system (BMS)) that monitors temperature, voltage, and current of the battery cell is driven to diagnose the state of the battery cell.

However, when the battery management apparatus is continuously driven in a low-voltage state of the battery cell such that the battery cell is over-discharged, it is not possible to regenerate the battery cell, making it impossible to use the entire battery pack.

### [DISCLOSURE]

### [TECHNICAL PROBLEM]

Embodiments disclosed herein provide a battery management apparatus and an operating method thereof in which over-discharging of a battery cell may be prevented.

Technical problems of the embodiments disclosed herein are not limited to the above-described technical problems, and other unmentioned technical problems would be clearly understood by one of ordinary skill in the art from the following description.

### [TECHNICAL SOLUTION]

A battery management apparatus according to an embodiment disclosed herein includes a buck converter configured to generate a driving voltage based on a voltage of a battery pack, a comparator configured to compare a divided voltage generated based on the voltage of the battery pack with a reference voltage and control an operation of the buck converter based on a result of the comparison, and a detector configured to detect whether the battery pack and a target device are connected and control an operation of the comparator based on a result of the detection.

According to an embodiment, the comparator may be further configured to generate a block signal for disabling the buck converter when the divided voltage is less than or equal to the reference voltage.

According to an embodiment, the buck converter may be turned off when the block signal is input from the comparator.

According to an embodiment, the battery management apparatus may operate in a Under Voltage Lock OUT (UVLO) mode when the buck converter is turned off.

According to an embodiment, the detector may include a photo coupler, and the detector may be further configured to transmit an enable voltage to the comparator when detecting that a target device is connected to the battery pack.

According to an embodiment, the comparator may be further configured to generate an opening signal for enabling the buck converter when the enable voltage is input from the detector.

According to an embodiment, the buck converter may be turned on when the opening signal is input from the comparator.

According to an embodiment, the battery management apparatus may operate in a wake-up mode when the buck converter is turned on.

According to an embodiment, the battery management apparatus may further include a voltage dividing resistor configured to generate the divided voltage by dividing the voltage of the battery pack based on input power of the comparator.

An operating method of a battery management apparatus according to an embodiment disclosed herein includes operations of generating, by a buck converter, a driving voltage based on a voltage of a battery pack, comparing, by a comparator, a divided voltage generated based on the voltage of the battery pack with a reference voltage, and controlling, by the comparator, an operation of the buck converter based on a result of the comparing.

According to an embodiment, the operation of controlling, by the comparator, the operation of the buck converter based on the result of the comparing may include generating a block signal for disabling the buck converter when the divided voltage is less than or equal to the reference voltage.

According to an embodiment, the operation of controlling, by the comparator, the operation of the buck converter based on the result of the comparing may include being, by the buck converter, turned off.

According to an embodiment, the operation of controlling, by the comparator, the operation of the buck converter based on the result of the comparing may include operating, by the battery management apparatus, in the UVLO mode.

According to an embodiment, the operating method may further include detecting, by the detector, whether the battery pack and a target device are connected and controlling an operation of the comparator based on a result of the detecting.

According to an embodiment, the operation of detecting, by the photo coupler, whether the battery pack and the target device are connected and controlling the operation of the comparator based on the result of the detecting may include transmitting an enable voltage to the comparator when detecting connection between the battery pack and the target device.

According to an embodiment, the operation of detecting, by the photo coupler, whether the battery pack and the target device are connected and controlling the operation of the comparator based on the result of the detecting may include generating an opening signal for enabling the buck converter when the enable voltage is input from the detector.

According to an embodiment, the operation of detecting, by the photo coupler, whether the battery pack and the target device are connected and controlling the operation of the comparator based on the result of the detecting may include receiving, by the buck converter, the opening signal from the comparator and thus being turned on.

### [ADVANTAGEOUS EFFECTS]

With a battery management apparatus and an operating method thereof according to an embodiment disclosed herein, it is possible to prevent over-discharge of a battery cell and improve the efficiency of the battery management apparatus.

### [BRIEF DESCRIPTION OF THE DRAWINGS]

FIG. 1 illustrates a configuration of a battery pack according to an embodiment disclosed herein.
FIG. 2 is a block diagram illustrating a configuration of a battery management apparatus, according to an embodiment disclosed herein.
FIG. 3 is a circuit diagram illustrating an implementation example of a battery management apparatus according to an embodiment disclosed herein.
FIG. 4 is a flowchart of an operating method of a battery management apparatus according to an embodiment disclosed herein.
FIG. 5 is a flowchart of an operating method of a battery management apparatus according to another embodiment disclosed herein.

### [MODE FOR INVENTION]

Hereinafter, some embodiments disclosed in this document will be described in detail with reference to the exemplary drawings. In adding reference numerals to components of each drawing, it should be noted that the same components are given the same reference numerals even though they are indicated in different drawings. In addition, in describing the embodiments disclosed in this document, when it is determined that a detailed description of a related known configuration or function interferes with the understanding of an embodiment disclosed in this document, the detailed description thereof will be omitted.

To describe a component of an embodiment disclosed herein, terms such as first, second, A, B, (a), (b), etc., may be used. These terms are used merely for distinguishing one component from another component and do not limit the component to the essence, sequence, order, etc., of the component. The terms used herein, including technical and scientific terms, have the same meanings as terms that are generally understood by those skilled in the art, as long as the terms are not differently defined. Generally, the terms defined in a generally used dictionary should be interpreted as having the same meanings as the contextual meanings of the relevant technology and should not be interpreted as having ideal or exaggerated meanings unless they are clearly defined in the present document.

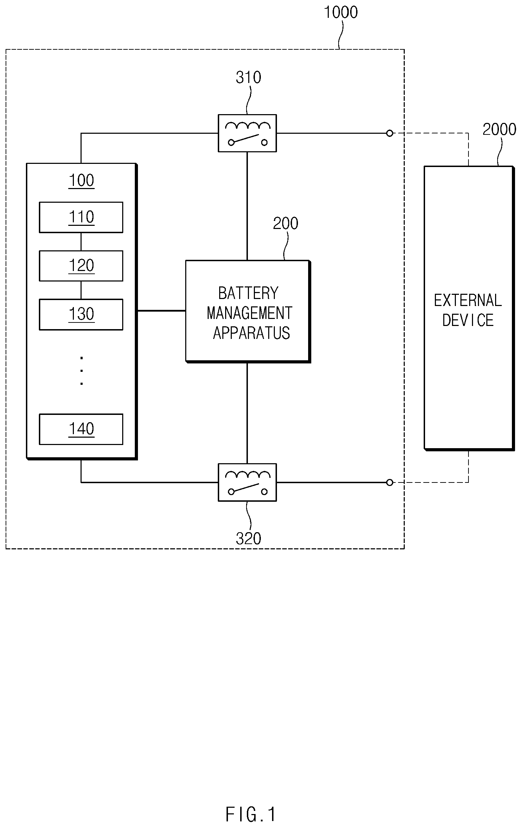

FIG. 1 illustrates a configuration of a battery pack according to an embodiment disclosed herein.

Referring to FIG. 1, a battery pack 1000 according to an embodiment disclosed herein may include a battery module 100, a battery management apparatus 200, and a switching unit 300.

The battery pack 1000 may supply power to a target device 2000. To this end, the battery pack 1000 may be electrically connected to the target device 2000. Herein, the target device 2000 may include electrical, electronical, or mechanical devices operating with power supplied from the battery pack 1000 including the plurality of battery cells 110, 120, 130, and 140, and for example, the target device 2000 may be, but not limited to, large products that require high output, such as electric vehicles or hybrid vehicles, and power storage devices that store surplus power or renewable energy or power storage devices for backup as well as small products such as digital cameras, P-DVDs, MP3P, mobile phones, PDAs, portable game devices, power tools, E-bikes, etc.

For example, when an external charging device (not shown) is connected to the target device 2000, the battery pack 1000 may be supplied with power from the target device 2000. For example, the battery module 100 and/or the plurality of battery cells 110, 120, 130, and 140 included in the battery pack 1000 may be charged using direct current power supplied from the external charging device connected to the target device 2000.

The battery module 100 may include a first battery cell 110, a second battery cell 120, a third battery cell 130, and a fourth battery cell 140. Although the plurality of battery cells are illustrated as four in FIG. 1, the present invention is not limited thereto, and the battery module 110 may include n battery cells (n is a natural number equal to or greater than 2). Meanwhile, although one battery module 100 is illustrated in FIG. 1, the battery module 100 may be configured in plural according to an embodiment.

The battery management apparatus (or a battery management system (BMS)) 200 may manage and/or control a state and/or an operation of the battery module 100. For example, the battery management apparatus 200 may manage and/or control the states and/or operations of the plurality of battery cells 110, 120, 130, and 140 included in the battery module 100. The battery management apparatus 200 may monitor a voltage, a current, a temperature, etc., of the battery module 100 and/or each of the plurality of battery cells 110, 120, 130, and 140 included in the battery module 100.

The battery management apparatus 200 may monitor cell balancing time of the battery module 100 and/or each of the plurality of battery cells 110, 120, 130, and 140 included in the battery module 100. Herein, the cell balancing time may be defined as a time required for balancing of the battery cell. For example, the battery management apparatus 200 may calculate a cell balancing time based on an SOC, a battery capacity, and a balancing efficiency of the battery module 100 and/or each of the plurality of battery cells 110, 120, 130, and 140 included in the battery module 100.

An operation mode of the battery management apparatus 200 may include a wake-up mode and a sleep mode. The wake-up mode may be defined as a state in which power is supplied to the battery management apparatus 200 and thus a process of the battery management apparatus 200 is driven. For example, the battery management apparatus 200 may consume 1A per time when operating in the wake-up mode.

The sleep mode may be defined as a state in which the battery management apparatus 200 supplies power to the target device 200 even when the process of the battery management apparatus 200 does not operate. According to an embodiment, the battery management apparatus 200 may be supplied with power from the battery module 100 when operating in the sleep mode. For example, when the battery management apparatus 200 operates in the sleep mode to supply power to the target device 2000, the battery management apparatus 200 may consume 5mA per time.

The battery management apparatus 200 may control an operation of the switching unit 300. For example, the battery management apparatus 200 may short-circuit the switching unit 300 to supply power to the target device 2000. The battery management apparatus 200 may short-circuit the switching unit 300 when a charging device is not connected to the battery module 100.

The switching unit 300 may be a switching device for controlling a current flow for charging or discharging of the battery module 100. The switching unit 300 may include a first switching unit 310 connected in series to a + terminal side of the battery module 100 or a second switching unit 320 connected in series to a - terminal side of the battery module 100. For example, the first switching unit 310 or the second switching unit 320 may be implemented in the form of a contactor. The contactor may open and close a flow of current through the battery module 100 by entering a switch-on state or a switch-off state according to a switching signal of the battery management apparatus 200.

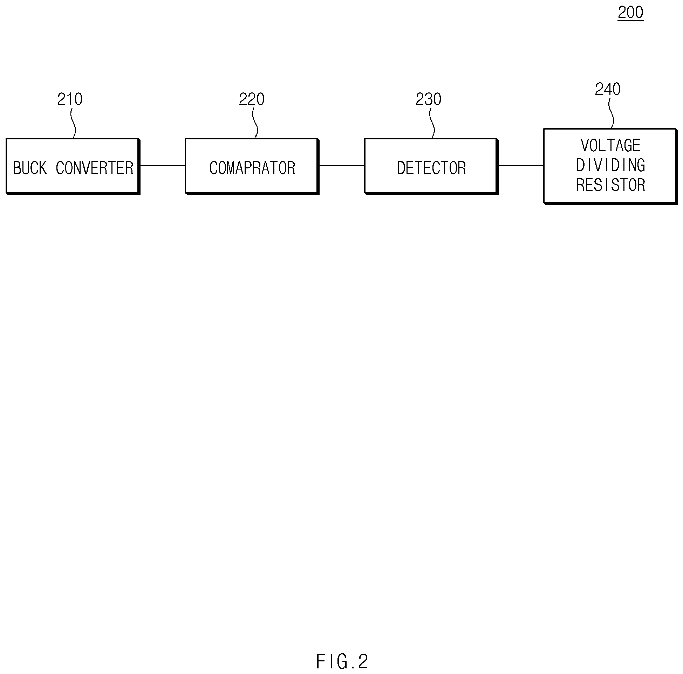

Hereinbelow, referring to FIG. 2, a configuration of the above-described battery management apparatus 200 will be described.

FIG. 2 is a block diagram illustrating a configuration of a battery management apparatus, according to an embodiment disclosed herein.

Referring to FIG. 2, the battery management apparatus 200 may include a buck converter 210, a comparator 220, a detector 230, and a voltage dividing resistor 240.

The buck converter 210 may generate a driving voltage of the battery management apparatus 200 based on a voltage of the battery module 100. The buck converter 210 may generate an output voltage to be applied to the target device 2000 based on a voltage of the battery module 100. For example, the buck converter 210 is a step-down converter that performs rectification through a diode and may be used as an uninsulated step-down switching DC/DC converter.

The buck converter 210 may perform a low-voltage locking (Enable/Under Voltage Lock OUT (EN/UVLO)) function. Herein, the EN/UVLO function may be a function in which when an input voltage applied to the buck converter 210 is less than or equal to an operating voltage range of the buck converter 210, the buck converter 210 stops an output and protects an output transistor and a load thereof. That is, the buck converter 210 may forcedly stop an operation of a circuit by using the EN/UVLO function.

The comparator 220 may compare a divided voltage generated based on the voltage of the battery module 100 with a reference voltage. Herein, the divided voltage may be generated through the voltage dividing resistor 240. The voltage dividing resistor 240 may divide the voltage of the battery module 100 based on input power of the comparator 220. For example, the voltage dividing resistor 240 may generate 1/10 of the voltage of the battery module 100 as the divided voltage.

The comparator 220 may control the operation of the buck converter 210 by determining whether the divided voltage generated based on the voltage of the battery module 100 is less than or equal to the reference voltage. More specifically, the comparator 220 may generate a block signal that disables the buck converter 210 when the divided voltage generated based on the voltage of the battery module 100 is less than or equal to the reference voltage.

For example, a normal voltage of the battery module 100 may be defined as 40 V to 60 V, a voltage of the low-voltage battery module 100 may be defined as 20 V to 30 V, and the voltage of the battery module 100 that has to be discarded due to an over-discharge state may be defined as 20 V or less. When the battery module 100 is left for a specific time or longer without being charged in a low-voltage state, the battery module 100 may reach to an over-discharge state after an elapse of a specific time due to current consumed for generation of a driving voltage of the battery management apparatus 200. When the battery module 100 reaches the over-discharge state, the battery cells included in 110, 120, 130, and 140 included in the battery module 100 may not be reproduced or recovered, making it impossible to use the entire battery pack 1000.

Thus, when the divided voltage based on the voltage of the battery module 100 is less than or equal to the reference voltage, the comparator 220 may prevent current from being consumed by the battery management apparatus 200 to drive the battery management apparatus 200 to be driven in an extremely low-power mode. When the battery management apparatus 200 operates in an UVLO mode, an output voltage consumed by the buck converter 210 may be removed, thus implementing a minimum power state. For example, the battery management apparatus 200 may consume 200 µA per time when operating in the UVLO mode.

For example, in case that an allowable capacity of the battery module 100 is 1.5 Ah until the battery module 100 reaches an over-discharge state, when the battery management apparatus 200 may consume 5 mA per time by operating in the sleep mode, then the battery module 100 may be discharged after 1/5 Ah/0.005 A= 300 h, i.e., about 300 hours. On the other hand, when the battery management apparatus 200 consumes 200 µA per time by operating in the UVLO mode, then the battery module 100 may be over-discharged after 1.5 Ah/0.0002 A = 7500 h, i.e., about 7500 hours.

That is, when the battery management apparatus 200 operates in the UVLO mode, a time until the battery module 100 reaches the over-discharge state may be extended in comparison to when the battery management apparatus 200 operates in the sleep mode. The battery management apparatus 200 may operate in the UVLO mode, thereby extending a standby time in which the battery module 100 may be supplied with power from the target device 2000.

The buck converter 210 may be turned off when a block signal is input from the comparator 220. That is, the buck converter 210 may not generate driving power based on the power of the battery module 100 any longer when the block signal is input from the comparator 220. When the buck converter 210 is turned off, the battery management apparatus 200 may operate in the UVLO mode because power is not supplied.

The detector 230 may detect whether the battery module 100 and the target device 2000 are connected, and control the operation of the comparator 220 based on a detection result. For example, the detector 230 may include a photo coupler. The following description will be described assuming that the detector 230 is a photo coupler. According to an embodiment, the photo coupler is a component where a light-emitting element and a light-receiving element are optically coupled with an insulating material therebetween, and may transmit an electric signal as light. For example, the photo coupler may include a light-emitting diode (LED) as a light-emitting element and a field effect transistor (FET) as a light-receiving element serving as a switch.

More specifically, the detector 230 may deliver an enable voltage to the comparator 220 when detecting connection between the battery module 100 and the target device 2000.

The detector 230 may detect whether the battery module 1000 and the target device 2000 are connected, and control the operation of the comparator 220 based on a detection result. That is, the detector 230 may detect whether the battery pack 1000 and the target device 2000 are connected.

More specifically, the detector 230 may deliver an enable voltage to the comparator 220 when detecting connection between the battery pack 1000 and the target device 2000.

The comparator 220 may generate an opening signal for enabling the buck converter 210 when an enable voltage is input from the detector 230. The buck converter 210 may be turned on when the opening signal is input from the comparator 220. When the buck converter 210 is turned on, the battery management apparatus 200 may operate in the wake-up mode.

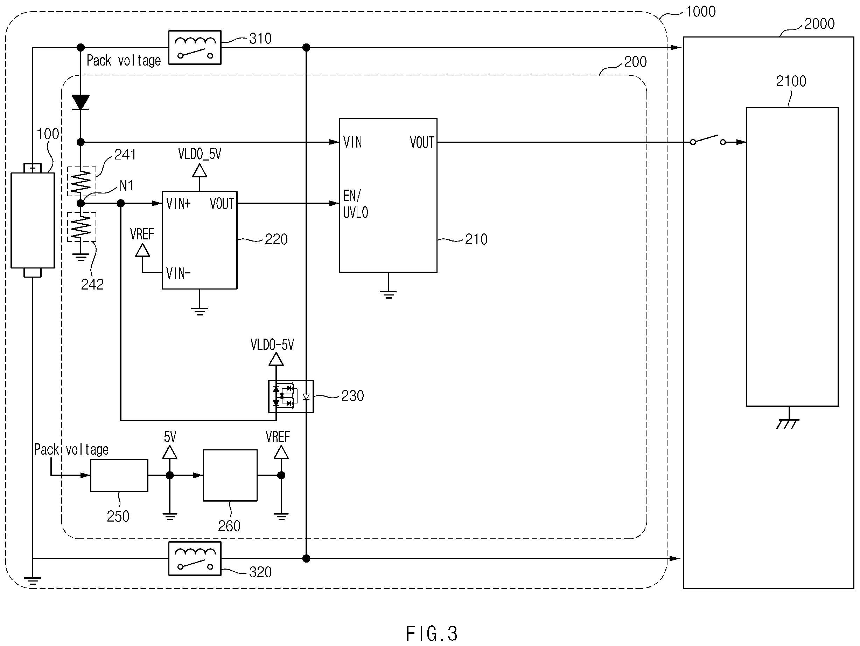

FIG. 3 is a circuit diagram illustrating an implementation example of a battery management apparatus according to an embodiment disclosed herein.

Referring to FIG. 3, the battery management apparatus 200 may include a buck converter 210, a comparator 220, a detector 230, a voltage dividing resistor 240, a linear regulator 250, and a reference voltage circuit 260.

The buck converter 210 may output a driving voltage by using an input voltage. The buck converter 210 may include a power input terminal V_IN and a power output terminal V_OUT. The power input terminal V_IN of the buck converter 210 may receive an input voltage from the battery module 100. For example, the power output terminal V_OUT of the buck converter 210 may output a driving voltage generated based on the input voltage of the battery module 100.

The driving voltage generated by the buck converter 210 may be supplied to a controller 2100 of the target device 2000. The controller 2100 of the target device 2000 may manage and/or control a state and/or an operation of an electric circuit including a plurality of electric elements and components included in the target device 2000. The controller 2100 may drive an electric circuit including electrical elements and components by using the driving voltage generated by the buck converter 210.

To the comparator 220, a predetermined voltage may be applied as power. A noninverting input terminal + V_IN+ of the comparator 220 may receive a divided voltage, and an inverting input terminal - V_IN- of the comparator 220 may receive a reference voltage V_ref. Herein, the reference voltage V_ref may be defined as a voltage supplied from the linear regulator 250 and the reference voltage circuit 260.

The linear regulator LDO 250 may convert power into preset specific voltage and supply the voltage. For example, the linear regulator 250 may output a preset voltage, 5 V, by using the voltage of the battery module 100.

A reference voltage circuit REF IC 260 may receive an output voltage of 5 V of the linear regulator 250 to generate a reference voltage V_REF. For example, the reference voltage circuit 260 may output a voltage of 3 V based on an output voltage of the linear regulator 250.

The divided voltage may be generated through the voltage dividing resistor 240. The voltage dividing resistor 240 may include a first resistor 241 and a second resistor 242. Magnitudes of resistances of the first resistor 241 and the second resistor 242 may be set based on input power of the comparator 220. For example, the divided voltage may be a voltage applied to a first node N1. According to an embodiment, a voltage across the second resistor 242 may be applied to the first node N1 through voltage division of the first resistor 241 and the second resistor 242.

The comparator 220 may compare a divided voltage with the reference voltage V_ref and control the operation of the buck converter 210 based on a comparison result. An output signal of the comparator 220 may be input to an EN/UVLO terminal of the buck converter 230. For example, the comparator 220 may output a logic high signal when the reference voltage V_ref is less than the divided voltage. For example, the comparator 220 may output a logic low signal when the reference voltage V_ref is equal to or greater than the divided voltage.

For example, the comparator 220 may output a block signal for disabling the buck converter 210 when the reference voltage V_ref is equal to or greater than the divided voltage. More specifically, the comparator 220 may input the logic low signal to the EN/UVLO terminal of the buck converter 230 when the battery module 100 is determined to be in the low-voltage state. The buck converter 210 may be turned off when the block signal of the comparator 220, i.e., the logic low signal is input to the EN/UVLO terminal. Thus, the buck converter 210 may be turned off and thus power may not be supplied, such that the battery management apparatus 200 may operate in the UVLO mode.

The detector 230 may detect whether the battery module 1000 and the target device 2000 are connected, and control the operation of the comparator 220 based on a detection result. The detector 230 may detect current flowing through both terminals thereof to determine that the target device 2000 is connected to the battery pack 1000 and thus power is supplied. When the detector 230 detects that the target device 2000 is connected to the battery pack 1000 and thus power is supplied, then the detector 230 may transmit an enable voltage V_LDO_5V to the comparator 220.

The comparator 220 may generate an opening signal for enabling the buck converter 210 when the enable voltage is input from the detector 230. For example, the comparator 220 may receive the enable voltage V_LDO_5V of 5 V from the detector 230 and compare the input voltage with the reference voltage.

For example, the comparator 220 may generate an opening signal for enabling the buck converter 210 when the reference voltage V_ref is less than the divided voltage. That is, the comparator 220 may input the logic high signal to the EN/UVLO terminal of the buck converter 230. The buck converter 210 may be turned on when the opening signal of the comparator 220, i.e., the logic high signal is input to the EN/UVLO terminal.

When the buck converter 210 is changed to the turn-on state, the battery management apparatus 200 may transmit a switching signal to the first switching unit 310 and the second switching unit 320. The first switching unit 310 and the second switching unit 320 may be switched on or switched off based on the switching signal of the battery management apparatus 200.

For example, when the first switching unit 310 and the second switching unit 320 may be switched on based on the switching signal of the battery management apparatus 200, the battery module 100 may be supplied with power from the target device 2000 and thus may be charged.

As described above, the battery management apparatus 200 according to an embodiment disclosed herein may prevent over-discharge of the battery cell.

Moreover, the battery management apparatus 200 may delay discarding of the battery pack 1000 due to over-discharge of the battery cell as much as possible by adding the UVLO mode to the operation mode.

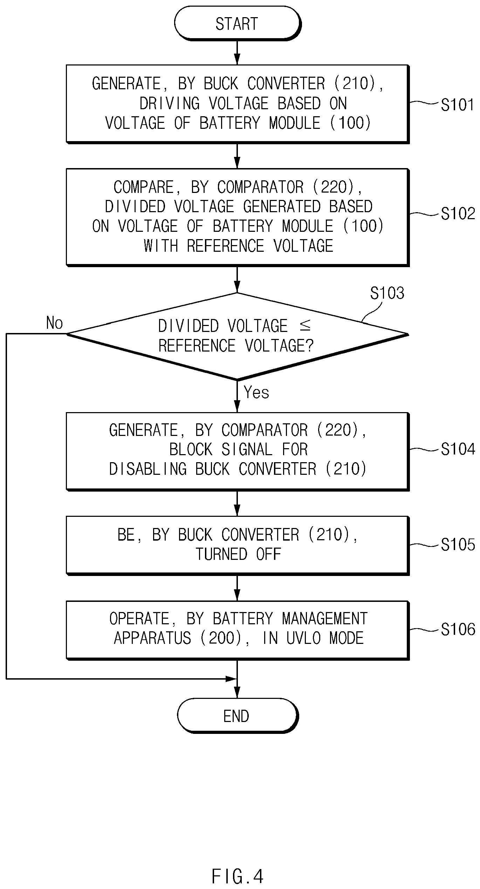

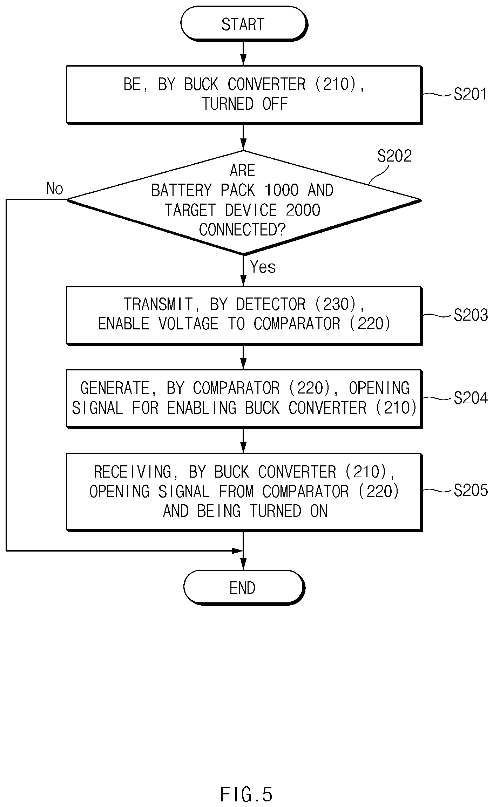

FIG. 4 is a flowchart of an operating method of a battery management apparatus according to an embodiment disclosed herein. FIG. 5 is a flowchart of an operating method of a battery management apparatus according to another embodiment disclosed herein.

Hereinbelow, referring to FIGS. 1 to 3, an operating method of the battery management apparatus 200 will be described.

The battery management apparatus 200 may include the buck converter 210, the comparator 220, the detector 230, and the voltage dividing resistor 240.

The battery management apparatus 200 may be substantially the same as the battery management apparatus 200 described with reference to FIGS. 1 to 3, and thus will be briefly described to avoid redundant description.

Referring to FIG. 4, an operating method of the battery management apparatus 200 may include operation S101 of generating, by the buck converter 210, a driving voltage based on a voltage of the battery module 100, operation S102 of comparing, by the comparator 220, a divided voltage generated based on the voltage of the battery module 100 with a reference voltage, operation S103 of determining, by the comparator 220, whether the divided voltage is less than or equal to the reference voltage, operation S104 of generating, by the comparator 220, a block signal for disabling the buck converter 210, operation S105 of being, by the buck converter 210, turned off, and operation S106 of operating, by the battery management apparatus 200, in an UVLO mode.

Hereinbelow, operations S101 through S106 will be described in detail.

In operation S101, the buck converter 210 may output a driving voltage by using an input voltage. In operation S101, the buck converter 210 may output a driving voltage based on a voltage of the battery module 100. In operation S101, for example, the buck converter 210 is a step-down converter that performs rectification through a diode and may be used as an uninsulated step-down switching DC/DC converter.

In operation S102, the comparator 220 may compare a divided voltage generated based on the voltage of the battery module 100 with a reference voltage.

In operation S103, the comparator 220 may determine whether the divided voltage is less than or equal to the reference voltage.

In operation S104, the comparator 220 may generate a block signal for disabling the buck converter 210 when the reference voltage is equal to or greater than the divided voltage.

In operation S105, the buck converter 210 may be turned off when the block signal is input from the comparator 220. In operation S105, the buck converter 210 may not generate driving power based on the power of the battery module 100 any longer when the block signal is input from the comparator 220.

In operation S106, when the buck converter 210 is turned off, the battery management apparatus 200 may operate in the UVLO mode because power is not supplied.

Referring to FIG. 5, an operation method of the battery management apparatus 200 may include operation S201 of being, by the buck converter 210, turned off, operation S202 of detecting, by the detector 230, whether the battery pack 1000 and the target device 2000 are connected, operation S203 of transmitting, by the detector 230, an enable voltage to the comparator 220, operation S204 of generating, by the comparator 220, an opening signal for enabling the buck converter 210, and operation S205 of receiving, by the buck converter 210, the opening signal from the comparator 220 and thus being turned on.

In operation S201, the buck converter 210 may be turned off when the block signal is input from the comparator 220. In operation S106, the buck converter 210 may be turned off and thus power may not be supplied, such that the battery management apparatus 200 may operate in the UVLO mode.

In operation S202, the detector 230 may detect whether the battery module 100 and the target device 2000 are connected, and control the operation of the comparator 220 based on a detection result.

In operation S203, the detector 230 may deliver an enable voltage to the comparator 220 when detecting connection between the battery module 100 and the target device 2000.

In operation S204, the comparator 220 may generate an opening signal for enabling the buck converter 210.

In operation S205, the opening signal is input to the buck converter 210 from the comparator 220 and thus the buck converter 210 may be turned on.

The above description is merely illustrative of the technical idea of the present disclosure, and various modifications and variations will be possible without departing from the essential characteristics of the present disclosure by those of ordinary skill in the art to which the present disclosure pertains.

Therefore, the embodiments disclosed in the present invention are intended for description rather than limitation of the technical spirit of the present disclosure and the scope of the technical spirit of the present invention is not limited by these embodiments. The protection scope of the present invention should be interpreted by the following claims, and all technical spirits within the same range should be understood to be included in the range of the present invention.

## Claims

1. A battery management apparatus, comprising:
a buck converter configured to generate a driving voltage based on a voltage of a battery pack;
a comparator configured to compare a divided voltage generated based on the voltage of the battery pack with a reference voltage and control an operation of the buck converter based on a result of the comparison; and
a detector configured to detect whether the battery pack and a target device are connected and control an operation of the comparator based on a result of the detection.

2. The battery management apparatus of claim 1, wherein the comparator is further configured to generate a block signal for disabling the buck converter when the divided voltage is less than or equal to the reference voltage.

3. The battery management apparatus of claim 2, wherein the buck converter is turned off when the block signal is input from the comparator.

4. The battery management apparatus of claim 3, wherein the battery management apparatus operates in a Under Voltage Lock OUT (UVLO) mode when the buck converter is turned off.

5. The battery management apparatus of claim 1, wherein the detector comprises a photo coupler, and the detector is further configured to transmit an enable voltage to the comparator when detecting that the target device is connected to the battery pack.

6. The battery management apparatus of claim 5, wherein the comparator is further configured to generate an opening signal for enabling the buck converter when the enable voltage is input from the detector.

7. The battery management apparatus of claim 6, wherein the buck converter is turned on when the opening signal is input from the comparator.

8. The battery management apparatus of claim 7, wherein the battery management apparatus operates in a wake-up mode when the buck converter is turned on.

9. The battery management apparatus of claim 1, further comprising a voltage dividing resistor configured to generate the divided voltage by dividing the voltage of the battery pack based on input power of the comparator.

10. An operating method of a battery management apparatus, the operating method comprising operations of:
generating, by a buck converter, a driving voltage based on a voltage of a battery pack;
comparing, by a comparator, a divided voltage generated based on the voltage of the battery pack with a reference voltage; and
controlling, by the comparator, an operation of the buck converter based on a result of the comparing.

11. The operating method of claim 10, wherein the operation of controlling, by the comparator, the operation of the buck converter based on the result of the comparing comprises generating a block signal for disabling the buck converter when the divided voltage is less than or equal to the reference voltage.

12. The operating method of claim 11, wherein the operation of controlling, by the comparator, the operation of the buck converter based on the result of the comparing comprises being, by the buck converter, turned off.

13. The operating method of claim 12, wherein the operation of controlling, by the comparator, the operation of the buck converter based on the result of the comparing comprises operating, by the battery management apparatus, in a Under Voltage Lock OUT (UVLO) mode.

14. The operating method of claim 10, further comprising detecting, by a detector, whether the battery pack and a target device are connected and controlling an operation of the comparator based on a result of the detecting.

15. The operating method of claim 14, wherein the operation of detecting, by the detector, whether the battery pack and the target device are connected and controlling the operation of the comparator based on the result of the detecting comprises transmitting an enable voltage to the comparator when detecting connection between the battery pack and the target device.

16. The operating method of claim 15, wherein the operation of detecting, by the detector, whether the battery pack and the target device are connected and controlling the operation of the comparator based on the result of the detecting comprises generating an opening signal for enabling the buck converter when the enable voltage is input from the detector.

17. The operating method of claim 16, wherein the operation of detecting, by the detector, whether the battery pack and the target device are connected and controlling the operation of the comparator based on the result of the detecting comprises receiving, by the buck converter, the opening signal from the comparator and thus being turned on.
